(19) Europäisches Patentamt
European Patent Office
Office européen des brevets

(11)  **EP 2 667 208 B1**

(12)  **FASCICULE DE BREVET EUROPEEN**

(45) Date de publication et mention
de la délivrance du brevet:
**17.09.2014  Bulletin 2014/38**

(51) Int Cl.:
***G01R 31/28*** *(2006.01)*    ***G01R 19/25*** *(2006.01)*

(21) Numéro de dépôt: **13167685.0**

(22) Date de dépôt: **14.05.2013**

(54) **Système électronique à capteurs intégrés, procédé d'estimation de valeur de grandeur physique de fonctionnement et programme d'ordinateur correspondant**

Elektronisches Integriertesensorensystem, Verfahren zum Schätzen des Wertes einer funktionellen physikalischen Grösse sowie ein entsprechendes Computerprogramm

Electronic integrated sensor system, method of estimating the value of a functional physical quantity and a corresponding computer program

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2012  FR 1254781**

(43) Date de publication de la demande:
**27.11.2013  Bulletin 2013/48**

(73) Titulaires:
• **Commissariat à l'Énergie Atomique et aux Énergies Alternatives 75015 Paris (FR)**
• **Centre National de la Recherche Scientifique 75794 Paris Cedex 16 (FR)**
• **Université Montpellier 2, Sciences et Techniques 34090 Montpellier (FR)**

(72) Inventeurs:
• **Lesecq, Suzanne 38190 Froges (FR)**
• **Beigne, Edith 38112 Meaudre (FR)**
• **Maurine, Philippe 30260 Quissac (FR)**
• **Vincent, Lionel 38600 Fontaine (FR)**

(74) Mandataire: **Bonnet, Michel Cabinet Bonnet 93, Rue Réaumur - Boîte 10 75002 Paris (FR)**

(56) Documents cités:
DE-A1-102005 048 015     US-A1- 2007 156 367
US-A1- 2008 026 489      US-A1- 2008 249 743

**Description**

La présente invention concerne un système électronique à capteurs intégrés, un procédé d'estimation de valeur de grandeur physique de fonctionnement et un programme d'ordinateur correspondant.

La présente invention s'applique en particulier au domaine des circuits intégrés.

La publication intitulée « A fully integrated 32 nm Multiprobe for dynamic PVT measurements with complex digital SoC », de L. Vincent, E. Beigne, L. Alacoque, S. Lesecq, C. Bour, Ph. Maurine, publiée en 2011 dans « 2nd European Workshop on CMOS Process Tuning and Variability, Vari 2011 » décrit un système électronique à capteurs intégrés, comportant :

- un circuit électronique présentant, en fonctionnement, une valeur d'une grandeur physique de fonctionnement, et
- un dispositif de mesure comportant :

  • des capteurs intégrés dans le circuit électronique de manière à fournir des mesures brutes sensibles à ladite valeur de la grandeur physique de fonctionnement, et
  • une unité de sortie destinée à fournir des mesures utiles à partir des mesures brutes.

US 2008/0249743 décrit un système similair. Dans la première publication, l'unité de sortie ne réalise aucun traitement particulier de sorte que les mesures utiles sont égales aux mesures brutes, et sont sous la forme de fréquences, sensibles à la température des capteurs, à la tension d'alimentation des capteurs et au processus de fabrication des capteurs. Ces trois variables de fonctionnement forment donc la grandeur physique de fonctionnement mentionnée précédemment.

Chaque fréquence dépend de ces trois variables de fonctionnement de sorte que la valeur précise de chacune des variables de fonctionnement n'est pas directement accessible à partir des fréquences. Cela signifie que les mesures brutes ne renseignent pas directement sur la valeur de la grandeur physique de fonctionnement.

Il peut ainsi être souhaité de prévoir un système électronique à capteurs intégrés, par exemple comme celui de la publication précédente ou de tout autre type, qui permette d'estimer la valeur de la grandeur physique de fonctionnement à partir des mesures utiles.

L'invention a donc pour objet un système électronique à capteurs intégrés, comportant :

- un circuit électronique présentant, en fonctionnement, une valeur $\overline{v}$ d'une grandeur physique de fonctionnement,
- un dispositif de mesure comportant :

  • des capteurs intégrés dans le circuit électronique de manière à fournir des mesures brutes $\{X_m\}$ sensibles à la valeur $\overline{v}$ de la grandeur physique de fonctionnement, et
  • une unité de sortie destinée à fournir des mesures utiles $\{X'_n\}$ à partir des mesure brutes $\{X_m\}$,

  comportant en outre :

- un dispositif de calcul de répartition destiné à déterminer une fonction de répartition courante F(x) associée aux mesures utiles $\{X'_n\}$,
- une mémoire dans laquelle des associations $\{A_k\}$ sont enregistrées, chaque association $A_k$ associant une fonction de répartition modèle $F_k(x)$ à une valeur modèle $v_k^*$ de la grandeur physique de fonctionnement,
- un dispositif de calcul d'estimation destiné à déterminer une estimation $\tilde{v}$ de la valeur $\overline{v}$ de la grandeur physique de fonctionnement à partir de la fonction de répartition courante F(x) et d'au moins une partie des associations $\{A_k\}$ enregistrées.

Ainsi, l'estimation $\tilde{v}$ peut être déterminée de manière fiable, c'est-à-dire que l'estimation $\tilde{v}$ obtenue est proche de la valeur $\overline{v}$.

De façon optionnelle, l'unité de sortie est destinée à combiner les mesures brutes $\{X_m\}$ pour calculer les mesures utiles $\{X'_n\}$, en sommant deux à deux les mesures brutes $\{X_m\}$ de sorte que chaque mesure utile $\{X'_n\}$ soit la somme de deux mesures brutes $\{X_m\}$.

De façon optionnelle également, le dispositif d'estimation comporte :

- une unité de sélection préalable destinée à sélectionner des fonctions de répartition modèles $\{F_{k1}(x)\}$ dans la

mémoire,

- une unité de test d'hypothèse destinée à déterminer, pour chaque fonction de répartition modèle préalablement sélectionnée $F_{k1}(x)$, une valeur distinctive $C_{k1}$, et à réaliser un test d'hypothèse utilisant les valeurs distinctives $\{C_{k1}\}$ afin de sélectionner statistiquement, parmi les fonctions de répartition modèles préalablement sélectionnées $\{F_{k1}(x)\}$, des fonctions de répartition modèles $\{F_{k2}(x)\}$,

- une unité de calcul d'estimation destinée à déterminer l'estimation $\tilde{v}$ à partir des valeurs modèles $\left\{v_{k2}^{*}\right\}$ associées aux fonctions de répartition modèles statistiquement sélectionnées $\{F_{k2}(x)\}$ et des valeurs distinctives $\{C_{k2}\}$ correspondantes.

De façon optionnelle également, l'unité de sélection préalable est destinée à sélectionner les fonctions de répartition modèles préalablement sélectionnées $\{F_{k1}(x)\}$ en fonction d'une estimation intermédiaire $\tilde{v}'$ de la valeur $\overline{v}$ de la grandeur physique de fonctionnement, et de manière prédéterminée en cas d'absence d'estimation intermédiaire, et l'unité de calcul d'estimation est destinée, d'une part, à déterminer l'estimation intermédiaire $\tilde{v}'$ à partir des valeurs $\left\{v_{k2}^{*}\right\}$ associées aux fonctions de répartition modèles statistiquement sélectionnées $\{F_{k2}(x)\}$ et des valeurs distinctives $\{C_{k2}\}$ correspondantes, et, d'autre part, suivant le résultat d'un test d'arrêt, soit à fournir l'estimation intermédiaire $\tilde{v}'$ à l'unité de sélection préalable de manière à former une boucle récursive de détermination d'estimations intermédiaires successives, soit à fournir la dernière estimation intermédiaire $\tilde{v}'$ déterminée comme estimation $\tilde{v}$.

De façon optionnelle également, l'unité de test d'hypothèse comporte :

- une unité de calcul de valeur distinctive destinée, pour chaque fonction de répartition modèle préalablement sélectionnée $F_{k1}(x)$, à déterminer une valeur discriminante $t_{k1}$ d'une fonction discriminante $T_{k1}(F)$ prédéterminée dépendant de la fonction de répartition courante $F(x)$ et de la fonction de répartition modèle préalablement sélectionnée $F_{k}(x)$, et à déterminer la valeur distinctive $C_{k1}$ à partir de la valeur discriminante $t_{k1}$, et

- une unité de sélection statistique destinée à sélectionner, parmi les fonctions de répartition modèles préalablement sélectionnées $\{F_{k1}(x)\}$, les fonctions de répartition modèles statistiquement sélectionnées $\{F_{k2}(x)\}$ à partir des valeurs distinctives $\{C_{k1}\}$.

De façon optionnelle également, l'unité de calcul de valeur distinctive est destinée, pour chaque valeur discriminante $t_{k1}$, à déterminer la probabilité critique $pc_{k1}$ associée à cette valeur discriminante $t_{k1}$, et dans lequel la valeur distinctive $C_{k1}$ est la probabilité critique $pc_{k1}$.

De façon optionnelle également, l'unité de sélection statistique est destinée à sélectionner, parmi les fonctions de répartition préalablement sélectionnées $\{F_{k1}(x)\}$, celles pour lesquelles la valeur distinctive $C_{k1}$ est supérieure à un seuil $\alpha$.

De façon optionnelle également, le seuil $\alpha$ est égal à un pourcentage prédéterminé de la plus grande des valeurs distinctives $\{C_{k1}\}$.

L'invention a également pour objet un procédé d'estimation de valeur de grandeur physique de fonctionnement, comportant :

- recevoir des mesures utiles $\{X'_n\}$ d'un dispositif de mesure comportant des capteurs intégrés dans un circuit électronique de manière à fournir des mesures brutes $\{X_m\}$ sensibles à une valeur $\overline{v}$ d'une grandeur physique de fonctionnement que le circuit électronique présente en fonctionnement, les mesures utiles $\{X'_n\}$ étant déterminées à partir des mesure brutes $\{X_m\}$,

- déterminer une fonction de répartition courante $F(x)$ associée aux mesures utiles $\{X'_n\}$,

- déterminer une estimation $\tilde{v}$ de la valeur $\overline{v}$ de la grandeur physique de fonctionnement à partir de la fonction de répartition courante $F(x)$ et d'au moins une partie d'associations $\{A_k\}$ enregistrées dans une mémoire, chaque association $A_k$ associant une fonction de répartition modèle $F_k(x)$ à une valeur modèle $v_{k}^{*}$ de la grandeur physique de fonctionnement.

L'invention a également pour objet un programme d'ordinateur téléchargeable depuis un réseau de communication et/ou enregistré sur un support lisible par ordinateur et/ou exécutable par un processeur, comprenant des instructions pour l'exécution des étapes d'un procédé selon l'invention lorsque ledit programme est exécuté sur un ordinateur.

L'invention sera mieux comprise à l'aide de la description qui va suivre, donnée uniquement à titre d'exemple et faite en se référant aux dessins annexés dans lesquels :

- la figure 1 représente schématiquement la structure générale d'un premier système électronique à capteurs intégrés selon l'invention,
- la figure 2 illustre les étapes successives d'un procédé de fonctionnement du système électronique à capteurs intégrés de la figure 1,
- la figure 3 représente schématiquement la structure générale d'un second système électronique à capteurs intégrés selon l'invention, et
- la figure 4 illustre les étapes successives d'un procédé de fonctionnement du système électronique à capteurs intégrés de la figure 3.

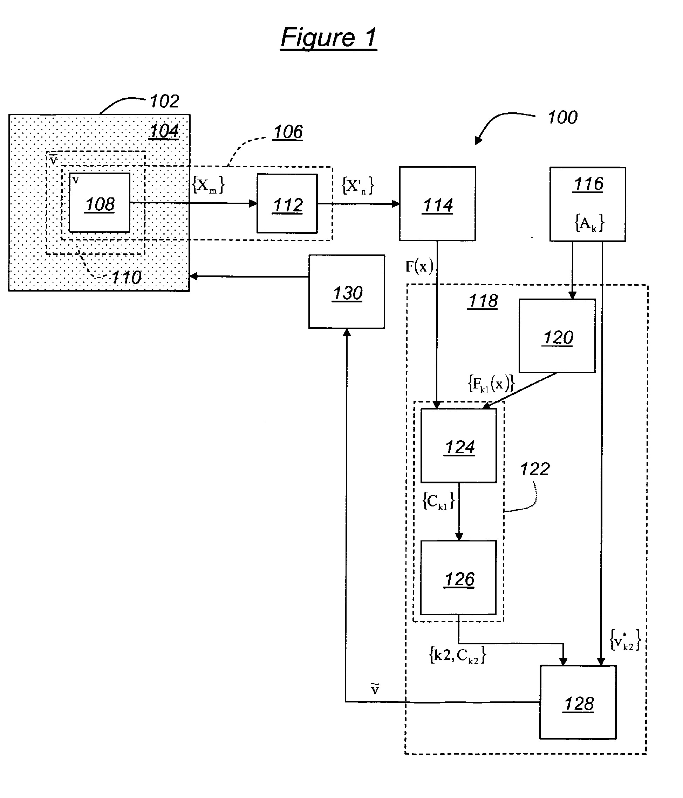

En référence à la figure 1, un premier système électronique 100 à capteurs intégrés va être décrit.

Le système électronique à capteurs intégrés 100 comporte tout d'abord une puce 102 sur laquelle des composants sont intégrés afin de former un circuit électronique 104 (indiqué en pointillés sur la figure 1) destiné à réaliser une ou plusieurs fonctions prédéterminées. La puce 102 est formée d'une tranche de semi-conducteur (« wafer » en anglais) sur laquelle sont gravés ou imprimés les composants du circuit électronique 104.

Le système électronique à capteurs intégrés 100 comporte en outre un dispositif de mesure 106.

Le dispositif de mesure 106 comporte tout d'abord des capteurs 108 intégrés à la puce 102 de manière à surveiller le fonctionnement d'une zone 110 du circuit électronique 104 s'étendant autour des capteurs 108. Les capteurs 108 sont ainsi eux aussi imprimés sur la tranche de semi-conducteur formant la puce 102. Cependant, les capteurs 108 ne participent pas à la réalisation de la ou des fonctions prédéterminées du circuit électronique 104.

Plus précisément, lors du fonctionnement du circuit électronique 104, la zone surveillée 110 présente une valeur $\bar{v}$ d'une grandeur physique de fonctionnement, et les capteurs 108 sont destinés à surveiller cette valeur $\bar{v}$.

Une grandeur physique est toute propriété ou ensemble de propriétés de la nature qui peuvent être quantifiées par la mesure ou le calcul, et dont les différentes valeurs possibles peuvent par exemple s'exprimer à l'aide d'un nombre, par exemple réel ou complexe, généralement accompagné d'une unité de mesure.

Les capteurs 108 sont destinés à être sensibles à la même grandeur physique de fonctionnement que la zone surveillée 110, c'est-à-dire à une grandeur physique de même nature. De manière idéale, lors de leur fonctionnement, les capteurs 108 présentent la même valeur $\bar{v}$ que la zone surveillée 110. Cependant, en pratique, il arrive qu'ils présentent une valeur v différente de la valeur $\bar{v}$, mais néanmoins proche de la valeur v, ou du moins présentent les mêmes variations que la valeur $\bar{v}$.

Ainsi, les capteurs 108 sont destinés à fournir, à chaque fois qu'ils sont interrogés, M mesures, appelées mesures brutes $\{X_m\}$ (m = 1...M), qui dépendent de la valeur v de la grandeur physique de fonctionnement. Par exemple, chaque capteur fournit une des mesures brutes $\{X_m\}$, de sorte qu'il y a autant de capteurs 106 que de mesures brutes $\{X_m\}$.

Comme expliqué précédemment, puisque la valeur v est sensiblement égale à la valeur $\bar{v}$, ou du moins présente les mêmes sensibilités et/ou variations, les mesures brutes $\{X_m\}$ sont donc sensibles à la valeur $\bar{v}$ de la grandeur physique de fonctionnement de la zone surveillée 110.

Dans l'exemple décrit, la grandeur physique de fonctionnement est bidimensionnelle : elle regroupe la température et la tension d'alimentation. Ainsi, la valeur $\bar{v}$ est composée de la valeur $\bar{T}$ de la température de la zone surveillée 110 et de la valeur $\bar{V}$ de tension d'alimentation de la zone surveillée soit: $\bar{v} = (\bar{T}, \bar{V})$, tandis que la valeur v est composée de la valeur T de la température des capteurs 108 et de la valeur V de la tension d'alimentation des capteurs 108, soit v = (T, V).

Dans l'exemple décrit, l'intégration des capteurs 108 signifie que les capteurs 108 sont imprimés sur la même puce 102 que le circuit électronique 104, en particulier selon le même processus d'impression. Cela signifie en outre que les capteurs 108 sont alimentés par la même alimentation, fournissant la tension d'alimentation, que le circuit électronique 104 et en particulier que la zone surveillée 110.

Dans l'exemple décrit, les capteurs 108 sont tous de même type et produisent donc le même type de mesure brute. Cependant, le comportement de chaque capteur (c'est-à-dire la mesure brute qu'il fournit) soumis aux mêmes variations de la grandeur physique de fonctionnement que les autres capteurs est de préférence le plus différent possible de celui des autres capteurs. Ainsi, les informations apportées par les capteurs 108 ne sont pas redondantes.

Par exemple, le dispositif appelé « Multiprobe » et décrit dans la publication intitulée « A Fully Integrated 32 nm MultiProbe for Dynamic PVT Measurements within Complex Digital SoC » de L. Vincent, E. Beigné, L. Alocoque, S. Lesecq, C. Bour et P. Maurine, et publiée dans « 2nd European Workshop on CMOS Variability », VARI 2011, 2011, est utilisé pour former les capteurs 108. Comme cela est décrit dans cette publication, chaque capteur 108 est alors un oscillateur en anneau dont la fréquence d'oscillation est sensible à sa valeur de température et à sa valeur de tension d'alimentation. Un tel oscillateur en anneau fournit, en tant que mesure brute, une mesure de fréquence d'oscillation.

Le dispositif de mesure 106 comporte en outre une unité de sortie 112 destinée à déterminer N mesures, appelées mesures utiles $\{X'_n\}$ (n =1...N), à partir des mesure brutes $\{X_m\}$.

De préférence, les mesures utiles $\{X'_n\}$ sont plus nombreuses que les mesures brutes $\{X_m\}$. En effet, cela permet d'augmenter la puissance du test statistique qui sera réalisé par les éléments décrits plus loin, c'est-à-dire que cela permet d'augmenter la probabilité de rejeter l'hypothèse nulle de ce test statistique.

Dans l'exemple décrit, l'unité de sortie 112 est destinée à combiner les mesures brutes $\{X_m\}$ pour calculer les mesures utiles $\{X'_n\}$. Par exemple, l'unité de sortie 112 est destinée à sommer deux à deux des mesures brutes $\{X_m\}$ de sorte que chaque mesure utile $\{X'_n\}$ soit la somme de deux mesures brutes $\{X_m\}$. En variante, l'unité de sortie 112 peut être destinée à faire la différence deux à deux des mesures brutes $\{X_m\}$ de sorte que chaque mesure utile $\{X'_n\}$ soit la différence de deux des mesures brutes $\{X_m\}$. Lors des études réalisées, il a été trouvé que la somme deux à deux des mesures brutes donnait de meilleurs résultats que la différence deux à deux. Encore en variante, l'unité de sortie 112 peut être destinée à faire la différence trois à trois des mesures brutes $\{X_m\}$, ou tout autre type de combinaison possible.

Le système électronique à capteurs intégrés 100 comporte en outre un dispositif de calcul de répartition 114 destiné à déterminer une fonction de répartition, appelée fonction de répartition courante F(x), associée aux mesures utiles $\{X'_n\}$.

Dans l'exemple décrit, la fonction de répartition courante F(x) représente la proportion des mesures utiles $\{X'_n\}$ dont la valeur est inférieure ou égale à x, et est donnée par :

$$F(x) = \frac{1}{N} \sum_{n=1}^{N} 1_{]-\infty, x]}(X'_n),$$

où $1_{]-\infty, x]}$ est une fonction valant 1 lorsque $X'_n$ est compris dans $]-\infty, x]$ et 0 sinon.

Ainsi, la fonction de répartition courante F(x) est une fonction à paliers croissante, et le nombre de paliers est égal au nombre N de mesures utiles $\{X'_n\}$.

Le système électronique à capteurs intégrés 100 comporte en outre une mémoire 116 dans laquelle K associations, appelées associations disponibles $\{A_k\}$ (avec k =1...K), sont enregistrées. Chaque association disponible $A_k$ associe une fonction de répartition modèle disponible $F_k(x)$ à une valeur modèle disponible $v_k^*$ de la grandeur physique de fonctionnement. Les associations disponibles $\{A_k\}$ sont par exemple enregistrées sous la forme d'une table de correspondance (ou LUT de l'anglais « Look-Up Table »). Chaque fonction de répartition modèle disponible $F_k(x)$ et valeur modèle disponible $v_k^*$ associée est par exemple obtenue au moyen d'une simulation du circuit électronique 104 et des capteurs 108, et/ou par une caractérisation des capteurs 108, et/ou par calibration des capteurs 108.

Les valeurs modèles disponibles $\left\{v_k^*\right\}$ forment ainsi un pavage de l'espace des valeurs possibles. Dans un mode de réalisation, le pavage est régulier. Dans l'exemple décrit, cela signifie que l'écart entre deux valeurs modèles de température ou de tension est toujours le même. Dans un autre mode de réalisation, le pavage est irrégulier. Dans l'exemple décrit, cela signifie que l'écart entre deux valeurs modèles de température ou de tension varie suivant les deux valeurs modèles considérées. En particulier cet écart peut être plus resserré pour les zones de l'espace des valeurs possibles les plus indécises. Dans encore un autre mode de réalisation, le pavage est en quinconce, ce qui permet de limiter le nombre de valeurs modèles disponibles tout en minimisant la distance entre ces valeurs.

Dans l'exemple décrit, chaque fonction de répartition modèle disponible $F_k(x)$ est obtenue en considérant des valeurs de mesures utiles modèles, ces dernières étant obtenues de manière empirique sur un système électronique à capteurs intégrés de test et/ou par modélisation et calculs. Ainsi, la fonction de répartition modèle disponible $F_k(x)$ est également une fonction à paliers croissante, le nombre de paliers, noté $M_k$, étant égal au nombre de mesures utiles modèles.

Dans un mode de réalisation particulier, toutes les fonctions de répartition modèles disponibles $F_k(x)$ présentent le même nombre de paliers, par exemple égal au nombre N de mesures utiles $\{X'_n\}$.

Le système électronique à capteurs intégrés 100 comporte en outre un dispositif d'estimation 118 destiné à déterminer une estimation $\tilde{v}$ de la valeur v de la grandeur physique de fonctionnement, et donc également de la valeur $\bar{v}$ de la grandeur physique de fonctionnement, à partir de la fonction de répartition courante F(x) et d'au moins une partie des associations disponibles $\{A_k\}$ enregistrées dans la mémoire 116.

Dans l'exemple décrit, le dispositif d'estimation 118 comporte tout d'abord une unité de sélection préalable 120 destinée à sélectionner dans la mémoire 116, parmi les fonctions de répartition modèles disponibles $\{F_k(x)\}$, des fonctions de répartition modèles, appelées fonctions de répartition modèles préalablement sélectionnées $\{F_{k1}(x)\}$ (avec $k1 \in [1,K]$).

Dans l'exemple de la figure 1, l'unité de sélection préalable 120 est destinée à sélectionner toutes les fonctions de répartition modèles disponibles {$F_k(x)$}.

Dans l'exemple décrit, le dispositif d'estimation 118 comporte en outre une unité de test d'hypothèse 122 destinée à réaliser un test d'hypothèse afin de sélectionner statistiquement, parmi les fonctions de répartition modèles préalablement sélectionnées {$F_{k1}(x)$}, des fonctions de répartition modèles, appelées fonctions de répartition modèles statistiquement sélectionnées {$F_{k2}(x)$} (avec k2 $\in$ [1,K]). Pour chaque fonction de répartition modèle préalablement sélectionnée $F_{k1}(x)$, le test d'hypothèse présente comme hypothèse nulle : « la fonction de répartition courante F(x) est égale à la fonction de répartition $F_{k1}(x)$ », et comme hypothèse contraire : « la fonction de répartition courante F(x) n'est pas égale à la fonction de répartition $F_{k1}(x)$ ». Le test d'hypothèse est par exemple le test d'hypothèse de Smirnov (variante moderne ou bien variante historique) ou bien le test d'hypothèse de Cramér-von Mises.

Dans l'exemple décrit, l'unité de test d'hypothèse 122 comporte tout d'abord une unité de calcul de valeur distinctive 124 destinée à déterminer, pour chaque fonction de répartition modèle préalablement sélectionnée $F_{k1}(x)$, une valeur distinctive $C_{ki}$. La valeur distinctive $C_{k1}$ représente un écart entre la fonction de répartition courante F(x) et la fonction de répartition modèle préalablement sélectionnée $F_{k1}(x)$.

Dans l'exemple décrit, l'unité de calcul de valeur distinctive 124 est destinée, pour chaque fonction de répartition modèle préalablement sélectionnée $F_{k1}(x)$, à déterminer une valeur, appelée valeur discriminante $t_{k1}$, d'une fonction prédéterminée, appelée fonction discriminante $T_{k1}(F)$. La fonction discriminante $T_{k1}(F)$ dépend de la fonction de répartition courante F(x) et de la fonction de répartition modèle préalablement sélectionnée $F_{k1}(x)$.

Dans l'exemple décrit, la fonction discriminante $T_{k1}(F)$ est choisie de sorte que la valeur $t_{k1}$ de $T_{k1}(F)$ a tendance à s'éloigner de 0 lorsque l'hypothèse nulle n'est pas vraie (test d'hypothèse bilatéral).

Par exemple, dans le cas du test d'hypothèse de Smirnov, la fonction discriminante $T_{k1}(F)$ est basée sur l'écart maximal entre les deux fonctions de répartition testées. Ainsi, le test d'hypothèse de Smirnov s'appuie sur l'observation d'un seul point des fonctions de répartition testées, à savoir celui correspondant à la distance maximale entre les deux fonctions de répartition. La fonction discriminante $T_{k1}(F)$ est alors :

$$T_{k1}(F) : t_{k1} = \sup_x \left| F_{k1}(x) - F(x) \right|.$$

Dans le cas du test de Cramér-von Mises, la fonction discriminante $T_{k1}(F)$ mesure la différence entre les deux fonctions de répartition testées sur l'intégralité de leurs domaines, ce qui en fait une bonne alternative au test d'hypothèse de Smirnov. La fonction discriminante $T_{k1}(F)$ vaut alors :

$$T_{k1}(F) : t_{k1} = \frac{NM_{k1}}{N + M_{k1}} \int_{-\infty}^{+\infty} \left[ F_{k1}(x) - F(x) \right]^2 dF(x).$$

Dans l'exemple décrit, les fonctions de répartition étant des fonctions à paliers, appelées couramment fonctions de répartition empiriques, la fonction discriminante $T_{k1}(F)$ est calculée par :

$$T_{k1}(F) : t_{k1} = \frac{U}{NM_{k1}(N + M_{k1})} - \frac{4NM_{k1} - 1}{6(M_{k1} + N)},$$

avec :

$$U = N \sum_{i=1}^{N} (r_i - i)^2 + M_{k1} \sum_{j=1}^{M_{k1}} (s_j - j)^2,$$

où, les valeurs utiles étant classées par ordre croissant dans un premier vecteur et les valeurs utiles modèles étant classées par ordre croissant dans un second vecteur, ces deux vecteurs étant combinés en un unique vecteur, appelé vecteur combiné, de sorte que les valeurs que le vecteur combiné contient sont également classées par ordre croissant, i est le rang des valeurs utiles dans le premier vecteur et $r_i$ est le rang de ces valeurs utiles dans le vecteur combiné, et j est le rang des valeurs utiles modèles dans le second vecteur et $s_j$ est le rang de ces valeurs utiles modèles dans le vecteur combiné.

L'unité de calcul de valeur distinctive 120 est en outre destinée à déterminer la valeur distinctive $C_{k1}$ à partir de la valeur discriminante $t_{k1}$.

Dans un mode de réalisation, la valeur distinctive $C_{k1}$ est la valeur discriminante $t_{k1}$. C'est par exemple le cas pour le test d'hypothèse de Smirnov historique.

Dans un autre mode de réalisation, la valeur distinctive $C_{k1}$ est une probabilité, appelée probabilité critique $pc_{k1}$, permettant d'obtenir une valeur de la fonction discriminante $T_{k1}(F)$ égale à la valeur $t_{k1}$ ou plus extrême (c'est-à-dire dans le cas du test d'hypothèse bilatéral, une valeur t telle que $|t| > |t_{k1}|$).

C'est par exemple le cas pour le test d'hypothèse de Smirnov moderne (communément appelé test de Kolmogorov-Smirnov), où la probabilité critique $pc_{k1}$ vaut :

$$pc_{k1} = 2\sum_{j=1}^{+\infty}(-1)^{j+1}e^{\left(-2k^2j^2\right)},$$

avec :

$$y = \sqrt{\frac{NM_{k1}}{N+M_{k1}}}\,T_{k1}(F).$$

En pratique, comme la somme sur j converge très rapidement vers sa valeur à l'infini, seul les J premiers termes de la somme sont déterminés, de sorte que $pc_{k1}$ est déterminé par :

$$pc_{k1} = 2\sum_{j=1}^{J}(-1)^{j+1}e^{\left(-2k^2j^2\right)}.$$

Par exemple, J est compris entre 3 et 100, ce qui suffit pour approcher de manière convenable la valeur à l'infini.

Dans le cas du test d'hypothèse de Cramér-von Mises, la valeur distinctive $C_{k1}$ peut également être la probabilité critique $pc_{k1}$. Dans ce cas, la probabilité critique $pc_{k1}$ vaut : avec :

$$pc_{k1} = \frac{T_{k1}(F)-\varepsilon T_{k1}(F)}{\sqrt{45\cdot Var(T_{k1}(F))}} + \frac{1}{6}$$

et :

$$\varepsilon T = \frac{1}{6} + \frac{1}{6(M_{k1}+N)},$$

$$\mathrm{Var}\big(T_{k1}(F)\big) = \frac{1}{45} \cdot \frac{M_{k1}+N+1}{(M_{k1}+N)^2} \cdot \frac{4M_{k1}N(M_{k1}+N)-3(M_{k1}^2+N^2)-2M_{k1}N}{4M_{k1}N} \; .$$

Dans l'exemple décrit, l'unité de test d'hypothèse 122 comporte en outre une unité de sélection statistique 126 destinée à sélectionner, parmi les fonctions de répartition modèles préalablement sélectionnées $\{F_{k1}(x)\}$, à partir de leurs valeurs distinctives $\{C_{k1}\}$, des fonctions de répartition modèles, appelées fonctions de répartition modèles statistiquement sélectionnées $\{F_{k2}(x)\}$. Plus précisément, l'unité de sélection statistique 126 est destinée à comparer la valeur distinctive $C_{k1}$ à un seuil pour sélectionner, en fonction de la comparaison, les fonctions de répartition modèles statistiquement sélectionnées $\{F_{k2}(x)\}$.

Dans l'exemple décrit, l'unité de sélection statistique 126 est destinée à fournir des identifiants des fonctions de répartition modèles statistiquement sélectionnées $\{F_{k2}(x)\}$, par exemples les indices k2, et les valeurs distinctives $\{C_{k2}\}$ correspondantes.

Dans le cas où la valeur distinctive $C_{k1}$ est la probabilité critique $pc_{k1}$, l'unité de sélection statistique 126 est destinée à sélectionner les fonctions de répartition modèles préalablement sélectionnées $\{F_{k1}(x)\}$ dont la valeur distinctive $C_{k1}$ est supérieure à un seuil $\alpha$. En effet, si la probabilité critique $pc_{k1}$ est inférieure au seuil $\alpha$, cela signifie que l'hypothèse nulle est rejetée.

Dans l'exemple décrit, le seuil $\alpha$ est égal à un pourcentage prédéterminé de la plus grande des valeurs distinctives $\{C_{k1}\}$. De préférence, le pourcentage prédéterminé est supérieur à 50%. Par exemple, le pourcentage prédéterminé est de 90% ou plus, ce qui permet de ne sélectionner que les fonctions de répartition modèles les plus probables. Il a en effet été trouvé que ce dernier cas donnait de meilleurs résultats.

Dans le cas où la valeur distinctive $C_{k1}$ est la valeur discriminante $t_{k1}$, afin de garantir qu'au moins une fonction de répartition modèle est sélectionnée et afin de diminuer la taille de mémoire nécessaire en évitant l'enregistrement de tables de fractiles, le seuil $\alpha$ est de préférence défini de la même manière que précédemment comme un pourcentage prédéterminé de la plus grande des valeurs distinctives $\{C_{k1}\}$.

Dans l'exemple décrit, le dispositif d'estimation 118 comporte en outre une unité de calcul d'estimation 128 destinée à déterminer l'estimation $\tilde{v}$ à partir, d'une part, des valeurs modèles $\left\{v_{k2}^{*}\right\}$ enregistrées dans la mémoire 116 et associées aux fonctions de répartition modèles statistiquement sélectionnées $\{F_{k2}(X)\}$ et, d'autre part, des valeurs distinctives $\{C_{k2}\}$ correspondantes. Par exemple, l'estimation $\tilde{v}$ est égale à la moyenne des valeurs sélectionnées $\left\{v_{k2}^{*}\right\}$ pondérée par les valeurs distinctives $\{C_{k2}\}$ correspondantes.

Dans le mode de réalisation décrit, le système électronique à capteurs intégrés 100 comporte en outre un dispositif de commande 130 destiné à commander le fonctionnement du circuit électronique 104 en fonction de l'estimation $\tilde{v}$. Le dispositif de commande 130 a par exemple pour but d'ajuster au mieux les performances du circuit électronique 104 dans un contexte de faible consommation électrique.

Par ailleurs, dans un mode de réalisation, tout ou partie du dispositif de calcul de répartition 114 et du dispositif d'estimation 118 est implémentée sous la forme d'un programme d'ordinateur exécuté par une unité de traitement (non représentée).

On notera que, de manière générale, tous les éléments décrits précédemment sauf les capteurs 108, la mémoire 116 et le dispositif de commande 130 peuvent être implémentés sous la forme d'un programme d'ordinateur exécuté par une unité de traitement (non représentée).

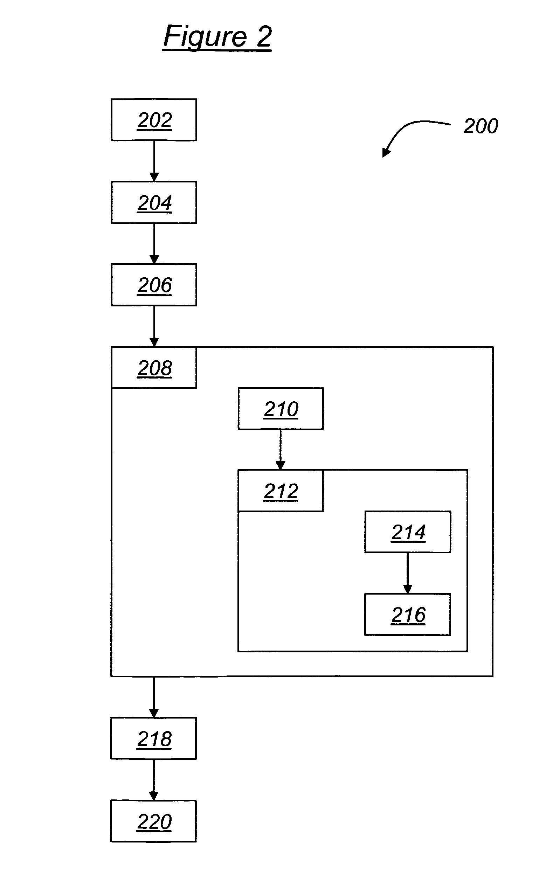

En référence à la figure 2, un procédé 200 de fonctionnement du système électronique à capteurs intégrés 100 va être décrit.

Au cours d'une étape 202, les capteurs 108 sont interrogés et fournissent les mesures brutes $\{X_m\}$.

Au cours d'une étape 204, l'unité de sortie 112 combine les mesures brutes $\{X_m\}$ pour calculer les mesures utiles $\{X'_n\}$.

Au cours d'une étape 206, le dispositif de calcul de répartition 114 reçoit les mesures utiles $\{X'_n\}$ et détermine la fonction de répartition courante F(x) associée aux mesures utiles $\{X'_n\}$.

Au cours d'une étape 208, le dispositif d'estimation 118 détermine une estimation $\tilde{v}$ de la valeur v de la grandeur physique de fonctionnement, et donc également de la valeur $\overline{v}$ de la grandeur physique de fonctionnement, à partir de la fonction de répartition courante F(x) et d'au moins une partie des associations disponibles $\{A_k\}$ enregistrées dans la mémoire 116. L'étape 208 comporte les étapes 210 à 216 suivantes.

Au cours d'une étape 210, l'unité de sélection préalable 120 sélectionne dans la mémoire 116, parmi les fonctions de répartition modèles disponibles {$F_k(x)$}, des fonctions de répartition modèles préalablement sélectionnées {$F_{k1}(x)$}. Dans l'exemple décrit, la sélection est prédéterminée. Par exemple, toutes les fonctions de répartition modèles disponibles {$F_k(x)$} sont sélectionnées.

Au cours d'une étape 212, l'unité de test d'hypothèse 122 réalise un test d'hypothèse afin de sélectionner, parmi les fonctions de répartition modèles préalablement sélectionnées {$F_{k1}(x)$}, des fonctions de répartition modèles statistiquement sélectionnées {$F_{k2}(x)$}. L'étape 212 comporte les étapes 214 et 216 suivantes.

Au cours d'une étape 214, l'unité de calcul de valeur distinctive 124 détermine, pour chaque fonction de répartition modèle préalablement sélectionnée $F_{k1}(x)$, la valeur distinctive $C_{k1}$ correspondante. Comme expliqué précédemment, suivant le mode de réalisation, cette valeur distinctive $C_{k1}$ est soit la valeur discriminante $t_{k1}$, soit la probabilité critique $pc_{k1}$ associée à cette valeur discriminante $t_{k1}$.

Au cours d'une étape 216, l'unité de sélection statistique 126 sélectionne, parmi les fonctions de répartition modèles préalablement sélectionnées {$F_{k1}(x)$}, à partir de leurs valeurs distinctives {$C_{k1}$}, les fonctions de répartition modèles statistiquement sélectionnées {$F_{k2}(x)$}. L'unité de sélection statistique fournit en outre des identifiants des fonctions de répartition modèles statistiquement sélectionnées {$F_{k2}(x)$} et les valeurs distinctives {$C_{k2}$} correspondantes.

Au cours d'une étape 218, l'unité de calcul d'estimation 128 détermine l'estimation $\tilde{v}$ à partir, d'une part, des valeurs $\left\{v_{k2}^{*}\right\}$ obtenues dans la mémoire 116 grâce aux identifiants et, d'autre part, des valeurs distinctives {$C_{k2}$}.

Au cours d'une étape 220, le dispositif de commande 130 commande le fonctionnement du circuit électronique 104 en fonction de l'estimation $\tilde{v}$.

Le procédé reprend ensuite à l'étape 202 pour une nouvelle estimation. Les estimations sont par exemple réalisées à intervalles de temps réguliers.

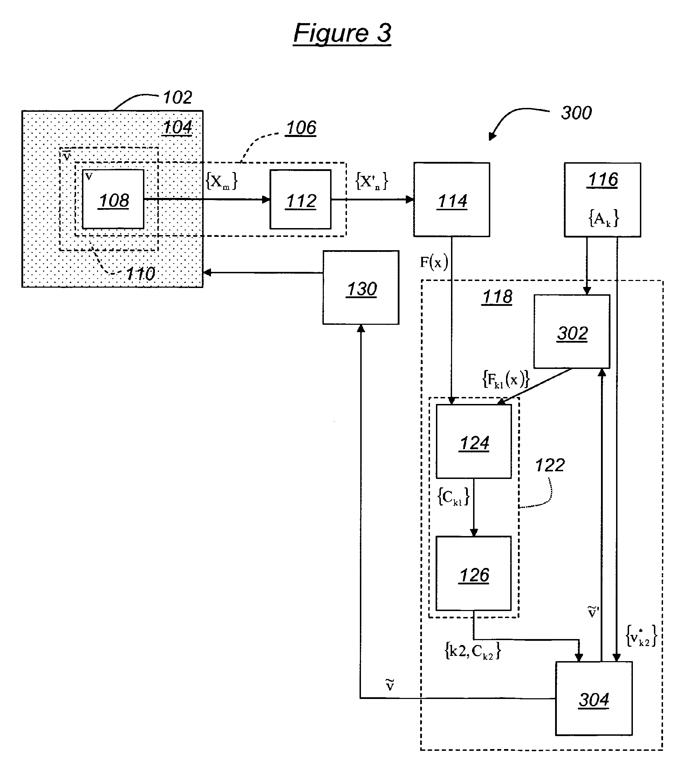

En référence à la figure 3, un second système électronique 300 à capteurs intégrés va être décrit.

Le système électronique à capteurs intégrés 300 est identique à celui de la figure 1, si ce n'est que l'unité de sélection préalable, portant à présent la référence 302, est destinée à sélectionner, parmi les fonctions de répartition modèles disponibles {$F_k(x)$} de la mémoire 116, les fonctions de répartition modèles préalablement sélectionnées {$F_{k1}(x)$} en fonction d'une estimation intermédiaire $\tilde{v}'$ de la valeur v de la grandeur physique de fonctionnement, et donc également de la valeur $\overline{v}$ de la grandeur physique de fonctionnement, et de manière prédéterminée en cas d'absence d'estimation intermédiaire.

Par exemple, en cas d'absence d'estimation intermédiaire, l'unité de sélection préalable 302 est destinée à sélectionner les fonctions de répartition modèles dont les valeurs modèles associées forment, dans l'exemple décrit, un pavage régulier de l'espace des valeurs possibles. Cependant, comme indiqué précédemment, le pavage pourrait être irrégulier.

Lorsqu'une estimation intermédiaire $\tilde{v}'$ est disponible, l'unité de sélection préalable est par exemple destinée à sélectionner des fonctions de répartition modèles dont les valeurs modèles associées se trouvent autour de l'estimation intermédiaire $\tilde{v}'$, par exemple à une distance inférieure ou égale à une distance prédéterminée. De préférence, les valeurs modèles associées aux fonctions de répartition modèles sélectionnées sont séparées par des distances décroissantes pour chaque nouvelle estimation intermédiaire $\tilde{v}'$. Cela permet de resserrer de manière récursive le pavage autour de la valeur la plus probable.

L'unité de sélection préalable 302 permet ainsi de limiter les calculs réalisés, et donc le coût en temps de calcul, tout en gardant de bons résultats. Par exemple, il a été trouvé que la même précision que pour le système électronique à capteurs intégrés de la figure 1 est obtenue avec une économie de calcul d'environ 60%.

En outre, l'unité de calcul d'estimation, portant à présent la référence 304, est destinée à déterminer l'estimation intermédiaire $\tilde{v}'$ à partir des valeurs distinctives {$C_{k2}$} déterminées par l'unité de sélection statistique 126. L'estimation intermédiaire $\tilde{v}'$ est par exemple égale à la moyenne des valeurs sélectionnées $\left\{v_{k2}^{*}\right\}$ pondérée par les valeurs distinctives {$C_{k2}$} correspondantes.

L'unité de calcul d'estimation 304 est en outre destinée à évaluer un test d'arrêt portant sur l'estimation intermédiaire et, suivant le résultat du test d'arrêt, soit à fournir l'estimation intermédiaire $\tilde{v}'$ à l'unité de sélection préalable 302 de manière à former une boucle récursive de détermination d'estimations intermédiaires $\tilde{v}'$, soit à fournir la dernière estimation intermédiaire $\tilde{v}'$ déterminée comme estimation $\tilde{v}$.

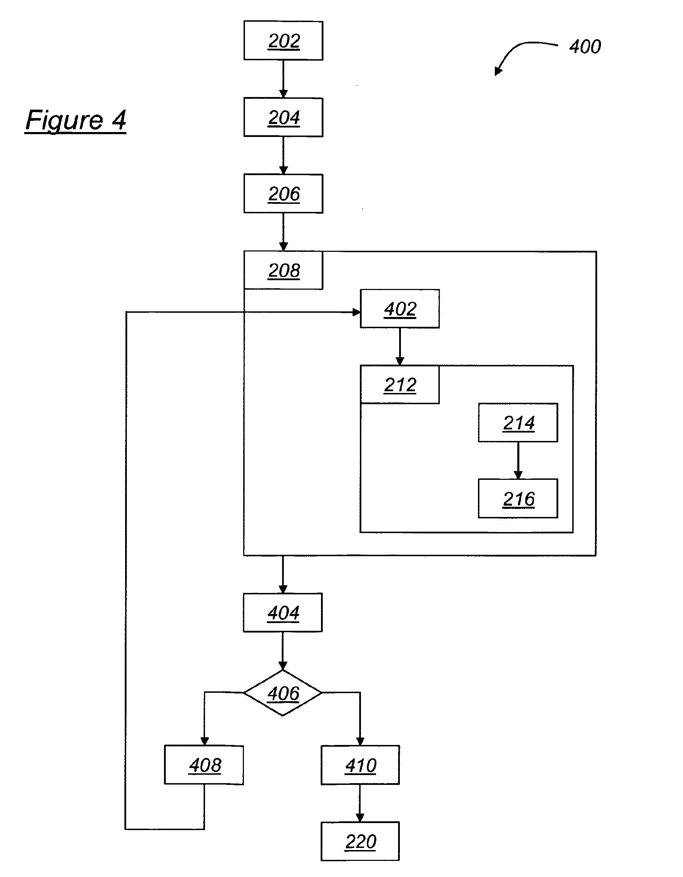

En référence à la figure 4, un procédé 400 de fonctionnement du système électronique à capteurs intégrés 300 va être décrit.

Le procédé de fonctionnement 400 est identique à celui de la figure 2, si ce n'est que l'étape 210 est remplacée par une étape 402 au cours de laquelle l'unité de sélection préalable 302 sélectionne, parmi les fonctions de répartition modèles disponibles {$F_k(x)$} de la mémoire 116, les fonctions de répartition modèles préalablement sélectionnées {$F_{k1}(x)$} en fonction d'une estimation intermédiaire $\tilde{v}'$ de la valeur v de la grandeur physique de fonctionnement, et donc également

de la valeur $\bar{v}$ de la grandeur physique de fonctionnement, et de manière prédéterminée en cas d'absence d'estimation intermédiaire.

En outre, l'étape 218 est remplacée par les étapes 404 à 410 suivantes.

Au cours d'une étape 404, l'unité de calcul d'estimation 304 détermine l'estimation intermédiaire $\tilde{v}'$ à partir des valeurs modèles $\left\{v_{k2}^{*}\right\}$ et des valeurs distinctives $\{C_{k2}\}$.

Au cours d'une étape 406, l'unité de calcul d'estimation 304 évalue un test d'arrêt portant sur l'estimation intermédiaire $\tilde{v}'$.

Au cours d'une étape 408, si le résultat du test d'arrêt est négatif, l'unité de calcul d'estimation 304 fournit l'estimation intermédiaire $\tilde{v}'$ à l'unité de sélection préalable 302 et le procédé 400 retourne à l'étape 402 de manière à former une boucle récursive de détermination d'estimations intermédiaires $\tilde{v}'$ successives.

Au cours d'une étape 410, si le résultat du test d'arrêt est positif, l'unité de calcul d'estimation 304 fournit la dernière estimation intermédiaire $\tilde{v}'$ déterminée comme estimation $\tilde{v}$.

Il apparaît clairement qu'un système électronique à capteurs intégrés tel que celui décrit précédemment permet d'estimer la valeur d'une grandeur physique de fonctionnement d'une zone d'un circuit électronique, et l'évolution de cette valeur au cours du temps. Le système électronique à capteurs intégrés permet en particulier de suivre une grandeur physique multidimensionnelle quand bien même les capteurs fournissent des mesures de nature identique.

Par ailleurs, l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

En particulier, la grandeur physique de fonctionnement n'est pas obligatoirement bidimensionnelle. Dans d'autres modes de réalisation, elle pourrait être monodimensionnelle ou multidimensionnelle à plus de deux dimensions.

En outre, la grandeur physique de fonctionnement pourrait inclure, en plus ou à la place de la température et de la tension d'alimentation, le processus de fabrication du circuit électronique. En effet, des circuits électroniques réalisés en suivant un même mode opératoire peuvent différer les uns des autres, par exemple pour la raison que des séries différentes de pièces ont été utilisées. Dans ce cas, les différentes valeurs caractérisant le processus de fabrication peuvent par exemple s'exprimer par un mot qualifiant les performances du circuit par rapport aux performances attendues, et non par un chiffre.

En outre, les mesures brutes ne sont pas obligatoirement combinées. Dans ce cas, l'unité de sortie peut être un simple fil et les mesures utiles sont alors égales aux mesures brutes.

En outre, dans une variante, l'unité de sélection statistique est destinée à déterminer si la plus grande des valeurs distinctives est inférieure ou non à un seuil prédéterminé. Si la plus grande des valeurs distinctives est inférieure au seuil prédéterminé, cela signifie qu'aucune fonction de répartition modèle ne ressemble à la fonction de répartition courante, c'est-à-dire qu'il est peu probable que les mesures utiles soit issues de l'une des fonctions de répartition modèles. Dans ce cas, l'unité de sélection statistique est destinée à modifier le fonctionnement de l'une ou plusieurs parmi : l'unité de sortie, l'unité de sélection préalable, l'unité de calcul de valeur distinctive et l'unité de sélection statistique, et à faire recommencer la détermination de l'estimation (finale ou intermédiaire suivant le mode de réalisation) à partir des mesures brutes. Par exemple, l'unité de sélection statistique peut modifier le type de combinaison utilisé pour obtenir les mesures utiles à partir des mesures brutes. Ou bien l'unité de sélection statistique peut modifier la manière avec laquelle l'unité de sélection préalable sélectionne des fonctions de répartition modèles disponibles. Ou bien l'unité de sélection statistique peut modifier le test utilisé pour le calcul de la valeur distinctive. Ou bien l'unité de sélection statistique peut modifier le seuil qu'elle utilise pour sélectionner les fonctions de répartition modèles statistiquement sélectionnées.

Dans les revendications qui suivent, les termes utilisés ne doivent pas être interprétés comme limitant les revendications aux modes de réalisation exposés dans la présente description.

## Revendications

1. Système électronique à capteurs intégrés (100 ; 300), comportant :

   - un circuit électronique (104) présentant, en fonctionnement, une valeur $\bar{v}$ d'une grandeur physique de fonctionnement,
   - un dispositif de mesure (106) comportant :

     • des capteurs (108) intégrés dans le circuit électronique (104) de manière à fournir des mesures brutes $\{X_m\}$ sensibles à la valeur $\bar{v}$ de la grandeur physique de fonctionnement,
     • une unité de sortie (112) destinée à fournir des mesures utiles $\{X'_n\}$ à partir des mesures brutes $\{X_m\}$,

**caractérisé en ce qu'**il comporte en outre :

- un dispositif de calcul de répartition (114) destiné à déterminer une fonction de répartition courante F(x) associée aux mesures utiles $\{X'_n\}$,
- une mémoire (116) dans laquelle des associations $\{A_k\}$ sont enregistrées, chaque association $A_k$ associant une fonction de répartition modèle $F_k(x)$ à une valeur modèle $v_k^*$ de la grandeur physique de fonctionnement,
- un dispositif de calcul d'estimation (118) destiné à déterminer une estimation $\tilde{v}$ de la valeur $\overline{v}$ de la grandeur physique de fonctionnement à partir de la fonction de répartition courante F(x) et d'au moins une partie des associations $\{A_k\}$ enregistrées.

2. Système électronique à capteurs intégrés (100 ; 300) selon la revendication 1, dans lequel l'unité de sortie (112) est destinée à combiner les mesures brutes $\{X_m\}$ pour calculer les mesures utiles $\{X'_n\}$, en sommant deux à deux les mesures brutes $\{X_m\}$ de sorte que chaque mesure utile $\{X'_n\}$ soit la somme de deux mesures brutes $\{X_m\}$.

3. Système électronique à capteurs intégrés (100 ; 300) selon la revendication 1 ou 2, dans lequel le dispositif d'estimation (118) comporte :

- une unité de sélection préalable (120 ; 302) destinée à sélectionner des fonctions de répartition modèles $\{F_{k1}(x)\}$ dans la mémoire (116),
- une unité de test d'hypothèse (122) destinée à déterminer, pour chaque fonction de répartition modèle préalablement sélectionnée $F_{k1}(x)$, une valeur distinctive $C_{k1}$, et à réaliser un test d'hypothèse utilisant les valeurs distinctives $\{C_{k1}\}$ afin de sélectionner statistiquement, parmi les fonctions de répartition modèles préalablement sélectionnées $\{F_{k1}(x)\}$, des fonctions de répartition modèles $\{F_{k2}(x)\}$,
- une unité de calcul d'estimation (128 ; 304) destinée à déterminer l'estimation $\tilde{v}$ à partir des valeurs modèles $\left\{v_{k2}^*\right\}$ associées aux fonctions de répartition modèles statistiquement sélectionnées $\{F_{k2}(x)\}$ et des valeurs distinctives $\{C_{k2}\}$ correspondantes.

4. Système électronique à capteurs intégrés (300) selon la revendication 3, dans lequel :

- l'unité de sélection préalable (302) est destinée à sélectionner les fonctions de répartition modèles préalablement sélectionnées $\{F_{k1}(x)\}$ en fonction d'une estimation intermédiaire $\tilde{v}$ de la valeur v de la grandeur physique de fonctionnement, et de manière prédéterminée en cas d'absence d'estimation intermédiaire, et
- l'unité de calcul d'estimation (304) est destinée, d'une part, à déterminer l'estimation intermédiaire $\tilde{v}'$ à partir des valeurs $\left\{v_{k2}^*\right\}$ associées aux fonctions de répartition modèles statistiquement sélectionnées $\{F_{k2}(x)\}$ et des valeurs distinctives $\{C_{k2}\}$ correspondantes, et, d'autre part, suivant le résultat d'un test d'arrêt, soit à fournir l'estimation intermédiaire $\tilde{v}'$ à l'unité de sélection préalable (302) de manière à former une boucle récursive de détermination d'estimations intermédiaires successives, soit à fournir la dernière estimation intermédiaire $\tilde{v}'$ déterminée comme estimation $\tilde{v}$.

5. Système électronique à capteurs intégrés (100 ; 300) selon la revendication 3 ou 4, dans lequel l'unité de test d'hypothèse (122) comporte :

- une unité de calcul de valeur distinctive (124) destinée, pour chaque fonction de répartition modèle préalablement sélectionnée $F_{k1}(x)$, à déterminer une valeur discriminante $t_{k1}$ d'une fonction discriminante $T_{k1}(F)$ prédéterminée dépendant de la fonction de répartition courante F(x) et de la fonction de répartition modèle préalablement sélectionnée $F_k(x)$, et à déterminer la valeur distinctive $C_{k1}$ à partir de la valeur discriminante $t_{k1}$,
- une unité de sélection statistique (126) destinée à sélectionner, parmi les fonctions de répartition modèles préalablement sélectionnées $\{F_{k1}(x)\}$, les fonctions de répartition modèles statistiquement sélectionnées $\{F_{k2}(x)\}$ à partir des valeurs distinctives $\{C_{k1}\}$.

6. Système électronique à capteurs intégrés (100 ; 300) selon la revendication 5, dans lequel l'unité de calcul de valeur distinctive (124) est destinée, pour chaque valeur discriminante $t_{k1}$, à déterminer la probabilité critique $pc_{k1}$ associée à cette valeur discriminante $t_{k1}$, et dans lequel la valeur distinctive $C_{k1}$ est la probabilité critique $pc_{k1}$.

**7.** Système électronique à capteurs intégrés (100 ; 200 ; 300) selon la revendication 5 ou 6, dans lequel l'unité de sélection statistique (126) est destinée à sélectionner, parmi les fonctions de répartition préalablement sélectionnées $\{F_{k1}(x)\}$, celles pour lesquelles la valeur distinctive $C_{k1}$ est supérieure à un seuil $\alpha$

**8.** Système électronique à capteurs intégrés (100 ; 300) selon la revendication 7, dans lequel le seuil $\alpha$ est égal à un pourcentage prédéterminé de la plus grande des valeurs distinctives $\{C_{k1}\}$.

**9.** Procédé d'estimation de valeur de grandeur physique de fonctionnement, comportant :

- recevoir (206) des mesures utiles $\{X'_n\}$ d'un dispositif de mesure (106) comportant des capteurs (108) intégrés dans un circuit électronique (104) de manière à fournir des mesures brutes $\{X_m\}$ sensibles à une valeur $\bar{v}$ d'une grandeur physique de fonctionnement que le circuit électronique (104) présente en fonctionnement, les mesures utiles $\{X'_n\}$ étant déterminées à partir des mesure brutes $\{X_m\}$,

**caractérisé en ce qu'**il comporte :

- déterminer (206) une fonction de répartition courante F(x) associée aux mesures utiles $\{X'_n\}$,
- déterminer (208) une estimation $\tilde{v}$ de la valeur $\bar{v}$ de la grandeur physique de fonctionnement à partir de la fonction de répartition courante F(x) et d'au moins une partie d'associations $\{A_k\}$ enregistrées dans une mémoire

(116), chaque association $A_k$ associant une fonction de répartition modèle $F_k(x)$ à une valeur modèle $v_k^*$ de la grandeur physique de fonctionnement.

**10.** Programme d'ordinateur téléchargeable depuis un réseau de communication et/ou enregistré sur un support lisible par ordinateur et/ou exécutable par un processeur, **caractérisé en ce qu'**il comprend des instructions pour l'exécution des étapes d'un procédé selon la revendication 9 lorsque ledit programme est exécuté sur un ordinateur.

**Patentansprüche**

**1.** Elektronisches Integriertesensorensystem (100; 300), umfassend:

- eine elektronische Schaltung (104), die in Funktion einen Wert $\bar{v}$ einer funktionellen physikalischen Größe aufweist,
- eine Messvorrichtung (106), umfassend:

  • Sensoren (108), die in die elektronische Schaltung (104) integriert sind, um Rohmessungen $\{X_m\}$ bereitzustellen, die gegenüber dem Wert $\bar{v}$ der funktionellen physikalischen Größe empfindlich sind,
  • eine Ausgangsgröße (112), die dazu bestimmt ist, nützliche Messungen $\{X'_n]$ ausgehend von den Rohmessungen $\{X_m\}$ bereitzustellen,

**dadurch gekennzeichnet, dass** es überdies umfasst:

- eine Verteilungsberechnungsvorrichtung (114), die dazu bestimmt ist, eine den nützlichen Messungen $\{X'_n\}$ zugeordnete laufende Verteilungsfunktion F(x) zu bestimmen,
- einen Speicher (116), in dem Zuordnungen $\{A_k\}$ gespeichert sind, wobei jede Zuordnung $A_k$ eine Modellverteilungsfunktion $F_k(x)$ einem Modellwert $v_k^*$ der funktionellen physikalischen Größe zuordnet,
- eine Schätzungsberechnungsvorrichtung (118), die dazu bestimmt ist, eine Schätzung $\tilde{v}$ des Werts $\tilde{v}$ der funktionellen physikalischen Größe ausgehend von der laufenden Verteilungsfunktion F(x) und mindestens eines Teils der gespeicherten Zuordnungen ($A_k$) zu bestimmen.

**2.** Elektronisches Integriertesensorensystem (100; 300) nach Anspruch 1, wobei die Ausgangsgröße (112) dazu bestimmt ist, die Rohmessungen $\{X_m]\}$ zu kombinieren, um die nützlichen Messungen $\{X'_n\}$ zu berechnen, indem die Rohmessungen $\{X_m\}$ zu zweit so summiert werden, dass jede nützliche Messung $\{X'_n\}$ die Summe von zwei Rohmessungen $\{X_m\}$ ist.

**3.** Elektronisches Integriertesensorsystem (100; 300) nach Anspruch 1 oder 2, wobei die Schätzvorrichtung (118) umfasst:

- eine Einheit zum vorherigen Auswählen (120; 302), die dazu bestimmt ist, Modelverteilungsfunktionen $\{F_{k1}(x)\}$ in dem Speicher (116) auszuwählen,
- eine Hypothesenteinheit (122), die dazu bestimmt ist, für jede vorher ausgewählte Modellverteilungsfunktion $F_{k1}(x)$ einen charakteristischen Wert $C_{k1}$ zu bestimmen und einen Hypothesentest unter Verwendung der charakteristischen Werte $\{C_{k1}\}$ durchzuführen, um statistisch unter den vorher ausgewählten Modellverteilungsfunktionen $\{F_{k1}(x)\}$ Modellverteilungsfunktionen $\{F_{k2}(x)\}$ auszuwählen,
- eine Schätzungberechnungseinheit (128; 304), die dazu bestimmt ist, die Schätzung $\tilde{v}$ ausgehend von den Modellwerten $\{v_{k2}^{*}\}$, die den statistisch ausgewählten Modellverteilungsfunktionen $\{F_{k2}(x)\}$ zugeordnet sind, und den entsprechenden charakteristischen Werten $\{C_{k2}\}$ zu bestimmen.

**4.** Elektronisches Integriertesensorsystem (300) nach Anspruch 3, wobei:

- die Einheit zum vorherigen Auswählen (302) dazu bestimmt ist, die vorher ausgewählten Modellverteilungsfunktionen $\{F_{k1}(x)\}$ abhängig von einer Zwischenschätzung $\tilde{v}'$ des Werts $\tilde{v}$ der funktionellen physikalischen Größe und im Falle des Nichtvorhandenseins einer Zwischenschätzung auf vorher bestimmte Weise auszuwählen, und
- die Einheit zum Berechnen einer Schätzung (304) einerseits dazu bestimmt ist, die Zwischenschätzung $\tilde{v}'$ ausgehend von den Werten $\{v_{k2}^{*}\}$, die den statistisch ausgewählten Modellverteilungsfunktionen $\{F_{k2}(x)\}$ zugeordnet sind, und den entsprechenden charakteristischen Werten $\{C_{k2}\}$ zu bestimmen, und andererseits dazu bestimmt ist, dem Ergebnis eines Abbruchtests folgend, entweder die Zwischenschätzung $\tilde{v}'$ der Einheit zum vorherigen Auswählen (302) bereitzustellen, um eine rekursive Schleife zum Bestimmen sukzessiver Zwischenschätzungen zu bilden, oder die letzte bestimmte Zwischenschätzung $\tilde{v}'$ als Schätzung $\tilde{v}$ bereitzustellen.

**5.** Elektronisches Integriertesensorsystem (100; 300) nach Anspruch 3 oder 4, wobei die Hypothesentesteinheit (122) umfasst:

- eine Einheit zum Berechnen eines charakteristischen Werts (124), die dazu bestimmt ist, für jede vorher ausgewählte Modellverteilungsfunktion $F_{k1}(x)$ einen Diskriminanzwert $t_{k1}$ einer vorbestimmten Diskriminanzfunktion $T_{k1}(F)$ in Abhängigkeit von der laufenden Verteilungsfunktion $F(x)$ und der vorher ausgewählten Modellverteilungsfunktion $F_k(x)$ zu bestimmen und einen charakteristischen Wert $C_{k1}$ ausgehend von dem Diskriminanzwert $t_{k1}$ zu bestimmen,
- eine Einheit zum statistischen Auswählen (126), die dazu bestimmt ist, unter den vorher ausgewählten Modellverteilungsfunktionen $\{F_{k1}(x)\}$ die statistisch ausgewählten Modellverteilungsfunktionen $\{F_{k2}(x)\}$ ausgehend von den charakteristischen Werten $\{C_{k1}\}$ auszuwählen.

**6.** Elektronisches Integriertesensorsystem (100; 300) nach Anspruch 5, wobei die Einheit zum Berechnen eines charakteristischen Werts (124) dazu bestimmt ist, für jeden Diskriminanzwert $t_{k1}$ die diesem Diskriminanzwert $t_{k1}$ zugeordnete kritische Wahrscheinlichkeit $pc_{k1}$ zu bestimmen, und wobei der unterscheidende Wert $C_{k1}$ die kritische Wahrscheinlichkeit $pc_{k1}$ ist.

**7.** Elektronisches Integriertesensorsystem (100; 200; 300) nach Anspruch 5 oder 6, wobei die Einheit zum statistischen Auswählen (126) dazu bestimmt ist, unter den vorher ausgewählten Verteilungsfunktionen $\{F_{k1}(x)\}$ diejenigen auszuwählen, bei denen der unterscheidende Wert $C_{k1}$ größer als ein Schwellenwert $\alpha$ ist.

**8.** Elektronisches Integriertesensorsystem (100; 300) nach Anspruch 7, wobei der Schwellenwert $\alpha$ gleich einem vorbestimmten Prozentsatz des höchsten charakteristischen Werts $\{C_{k1}\}$ ist.

**9.** Verfahren zum Schätzen eines Werts einer funktionellen physikalischen Größe, umfassend:

- Empfangen (206) nützlicher Messungen $\{X'_n\}$ von einer Messvorrichtung (106), die Sensoren (108) umfasst, die in eine elektronische Schaltung (104) integriert sind, um Rohmessungen $\{X_m\}$ bereitzustellen, die empfindlich für einen Wert $\bar{v}$ einer funktionellen physikalischen Größe sind, die die elektronische Schaltung (104) in Funktion aufweist, wobei die nützlichen Messungen $\{X'_n\}$ ausgehend von den Rohmessungen $\{X_m\}$ bestimmt sind, **dadurch gekennzeichnet**, das es umfasst:

- Bestimmen (206) einer den nützlichen Messungen $\{X'_n\}$ zugeordneten laufenden Verteilungsfunktion F(x),
- Bestimmen (208) einer Schätzung $\tilde{v}$ des Werts $\bar{v}$ der funktionellen physikalischen Größe ausgehend von der laufenden Verteilungsfunktion F(x) und mindestens einem Teil der in einem Speicher (116) gespeicherten Zuordnungen $\{A_k\}$, wobei jede Zuordnung $A_k$ eine Modellverteilungsfunktion $F_k(x)$ einem Modellwert $v_k^*$ der funktionellen physikalischen Größe zuordnet.

10. Aus einem Kommunikationsnetz herunterladbares und/oder auf einem computerlesbaren Datenträger gespeichertes und/oder von einem Prozessor ausführbares Computerprogramm, **dadurch gekennzeichnet, dass** es Anweisungen zur Ausführung der Schritte eines Verfahrens nach Anspruch 9 umfasst, wenn das Programm auf einem Computer ausgeführt wird.

**Claims**

1. Electronic system with embedded sensors (100; 300), comprising:

    - an electronic circuit (104) exhibiting, in operation, a value $\bar{v}$ of an operating physical quantity,
    - a measurement device (106) comprising:

        • sensors (108) embedded in the electronic circuit (104) so as to provide raw measurements $\{X_m\}$ sensitive to the value $\bar{v}$ of the operating physical quantity,
        • an output unit (112) for providing useful measurements $\{X'_n\}$ on the basis of the raw measurements $\{X_m\}$,

    further comprising:

        - a distribution calculation device (114) for determining a current distribution function F(x) associated with the useful measurements $\{X'_n\}$,
        - a memory (116) wherein associations $\{A_k\}$ are saved, each association $A_k$ associating a model distribution function $F_k(x)$ with a model value $v_k^*$ of the operating physical quantity,
        - an estimation calculation device (118) for determining an estimation $\tilde{v}$ of the value $\bar{v}$ of the operating physical quantity on the basis of the current distribution function F(x) and at least a portion of the saved associations $\{A_k\}$.

2. Electronic system with embedded sensors (100; 300) according to claim 1, wherein the output unit (112) is suitable for combining the raw measurements $\{X_m\}$ to calculate the useful measurements $\{X'_n\}$, by adding the raw measurements $\{X_m\}$ in pairs such that each useful measurement $\{X'_n\}$ is the sum of two raw measurements $\{X_m\}$.

3. Electronic system with embedded sensors (100; 300) according to claim 1 or 2, wherein the estimation device (118) comprises:

    - a preliminary selection unit (120; 302) for selecting model distribution functions $\{F_{k1}(x)\}$ in the memory (116),
    - a hypothesis testing unit (122) for determining, for each previously selected model distribution function $F_{k1}(x)$, a distinctive value $C_{k1}$, and for performing a hypothesis test using the distinctive values $\{C_{k1}\}$ to statistically select, from the previously selected model distribution functions $\{F_{k1}(x)\}$, model distribution functions $\{F_{k2}(x)\}$,
    - an estimation calculation unit (128; 304) for determining the estimation $\tilde{v}$ on the basis of the model values $\left\{v_{k2}^*\right\}$ associated with the statistically selected model distribution functions $\{F_{k2}(x)\}$ and the corresponding distinctive values $\{C_{k2}\}$.

4. Electronic system with embedded sensors (300) according to claim 3, wherein:

    - the preliminary selection unit (302) is suitable for selecting the previously selected model distribution functions

$\{F_{k1}(x)\}$ according to an intermediate estimation $\tilde{v}'$ of the value $\bar{v}$ of the operating physical quantity, in a predetermined manner in the event of absence of an intermediate estimation, and
- the estimation calculation unit (304) is suitable for determining the intermediate estimation $\tilde{v}'$ on the basis of the values $\left\{v_{k2}^{*}\right\}$ associated with the statistically selected model distribution functions $\{F_{k2}(x)\}$ and the corresponding distinctive values $\{C_{k2}\}$, and, according to the result of a stop test, either providing the intermediate estimation $\tilde{v}'$ to the preliminary selection unit (302) so as to form a recursive successive intermediate estimation determination loop, or providing the latest intermediate estimation $\tilde{v}'$ determined as the estimation $\tilde{v}$.

5. Electronic system with embedded sensors (100; 300) according to claim 3 or 4, wherein the hypothesis testing unit (122) comprises:

- a distinctive value calculation unit (124) for determining, for each previously selected model distribution function $F_{k1}(x)$, a discriminant value $t_{k1}$ of a predetermined discriminant function $T_{k1}(F)$ dependent on the current distribution function $F(x)$ and the previously selected model distribution function $F_k(x)$, and for determining the distinctive value $C_{k1}$ on the basis of the discriminant value $t_{k1}$,
- a statistical selection unit (126) for selecting, from the previously selected model distribution functions $\{F_{k1}(x)\}$, the statistically selected model distribution functions $\{F_{k2}(x)\}$ on the basis of the distinctive values $\{C_{k1}\}$.

6. Electronic system with embedded sensors (100; 300) according to claim 5, wherein the distinctive value calculation unit (124) is suitable for determining, for each discriminant value $t_{k1}$, the critical probability $pc_{k1}$ associated with discriminant value $t_{k1}$, and wherein the distinctive value $C_{k1}$ is the critical probability $pc_{k1}$.

7. Electronic system with embedded sensors (100; 200; 300) according to claim 5 or 6, wherein the statistical selection unit (126) is suitable for selecting, from the previously selected distribution functions $\{F_{k1}(x)\}$, those for which the distinctive value $C_{k1}$ is greater than a threshold $\alpha$.

8. Electronic system with embedded sensors (100; 300) according to claim 7, wherein the threshold $\alpha$ is equal to a predetermined percentage of the greatest of the distinctive values $\{C_{k1}\}$.

9. Method for estimating an operating physical quantity value, comprising:

- receiving (206) useful measurements $\{X'_n\}$ from a measurement device (106) comprising embedded sensors (108) in an electronic circuit (104) so as to provide raw measurements $\{X_m\}$ sensitive to a value $\bar{v}$ of an operating physical quantity exhibited by the electronic circuit (104) in operation, wherein the useful measurements $\{X'_n\}$ are determined on the basis of the raw measurements $\{X_m\}$, **characterised in that** it comprises:
- determining (206) a current distribution function $F(x)$ associated with the useful measurements $\{X'_n\}$,
- determining (208) an estimation $\tilde{v}$ of the value $\bar{v}$ of the operating physical quantity on the basis of the current distribution function $F(x)$ and at least a portion of associations $\{A_k\}$ saved in a memory (116), wherein each association $A_k$ associates a model distribution function $F_k(x)$ with a model value $v_k^{*}$ of the operating physical quantity.

10. Computer program downloadable from a communication network and/or saved on a computer-readable medium and/or executable by a processor, comprising instructions for executing the steps of a method according to claim 9 when said program is executed on a computer.

## Figure 1

# Figure 2

EP 2 667 208 B1

## Figure 3

18

Figure 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080249743 A

**Littérature non-brevet citée dans la description**

- **L. VINCENT ; E. BEIGNE ; L. ALACOQUE ; S. LESECQ ; C. BOUR ; PH. MAURINE.** A fully integrated 32 nm Multiprobe for dynamic PVT measurements with complex digital SoC. *2nd European Workshop on CMOS Process Tuning and Variability,* 2011

- A Fully Integrated 32 nm MultiProbe for Dynamic PVT Measurements within Complex Digital SoC. **DE L. VINCENT ; E. BEIGNÉ ; L. ALOCOQUE ; S. LESECQ ; C. BOUR ; P. MAURINE.** 2nd European Workshop on CMOS Variability. 2011